# EUROPEAN PATENT APPLICATION

(11) **EP 2 079 084 A1**
(43) Date of publication of application: **15.07.2009**
(21) Application number: 07829106.9
(22) Date of filing: 03.10.2007
(51) Int. Cl.: H01B 5/00, B22F 1/02, C09J 9/02, C09J 11/04, H01B 1/22, H01B 13/00, H01R 11/01, H01R 43/00

(54) **COATED PARTICLE AND METHOD FOR PRODUCING THE SAME, ANISOTROPIC CONDUCTIVE ADHESIVE COMPOSITION USING COATED PARTICLE, AND ANISOTROPIC CONDUCTIVE ADHESIVE FILM**

(30) Priority: 17.10.2006 JP 2006282617; 18.06.2007 JP 2007160533
(71) Applicant: Hitachi Chemical Company, Ltd., Tokyo 163-0449 (JP)
(72) Inventor: TAKAI, Kenji, Tsukuba-shi Ibaraki 3004247 (JP); TAKANE, Nobuaki, Tsukuba-shi Ibaraki 3004247 (JP)
(74) Representative: Jönsson, Hans-Peter
(86) International application number: PCT/JP2007/069367
(87) International publication number: WO 2008/047600

(57) **Abstract**

A coated particle 10 comprising a functional group-containing conductive particle at least partially surface-coated with an insulating material, wherein the conductive particle has a metal surface and at least a part of the metal surface has a functional group, and wherein the insulating material comprises polymer electrolytes 4 and an insulating particles 6 made of an inorganic oxide having a hydroxy group on at least a part of a surface thereof.

## Description

### Technical Field

The present invention relates to a coated particle and a method for producing the same, an anisotropic conductive adhesive composition using the coated particle, and an anisotropic conductive adhesive film.

### Background Art

A method of mounting a liquid crystal-driving IC on a liquid crystal display glass panel is divided largely into two categories of a COG (Chip-on-Glass) mounting method and a COF (Chip-on-Flex) mounting method. In the COG mounting method, an anisotropic conductive adhesive composition containing conductive particles is used to directly bond a liquid crystal IC onto a glass panel. On the other hand, in the COF mounting method, a liquid crystal-driving IC is bonded to a flexible tape having a metal wiring followed by bonding via an anisotropic conductive adhesive composition containing conductive particles to a glass panel. The anisotropic electroconductivity here means that the electric continuity is maintained in a pressured direction and the insulating property is maintained in a non-pressured direction.

Recently, in these technical fields, as the high definition is more forwarded in liquid crystal display, a gold bump that is a circuit electrode of a liquid crystal-driving IC is demanded to be further narrower in pitch and further smaller in area. In this connection, there is a problem in that conductive particles of the anisotropic conductive adhesive composition flow out between adjacent circuit electrodes to cause short-circuiting. Furthermore, there is another problem in that when the conductive particles flow out between adjacent circuit electrodes, the number of conductive particles in the anisotropic conductive adhesive composition trapped between a gold bump and a glass panel decreases to raise connection resistance between facing circuit electrodes, thereby connection failure is generated.

In this connection, as methods for overcoming the problems, a method where an insulating adhesive layer is formed on at least one surface of an anisotropic conductive adhesive layer to inhibit the connection quality in the COG mounting or COF mounting from deteriorating (see, Patent Document 1), a method where an entire surface of the conductive particles is coated with an insulating film (see, Patent Document 2) and a method where insulating particles coat a surface of conductive particle (see, Patent Documents 3 and 4) have been proposed.
Patent Document 1: Japanese Patent Laid-Open No. 8-279371
Patent Document 2: Japanese Patent No. 2794009
Patent Document 3: Japanese Patent No. 2748705
Patent Document 4: WO03/025955

### Disclosure of Invention

### Problems to be Solved by the Invention

However, according to a method where an insulating adhesive layer is formed on one surface of an anisotropic conductive adhesive layer like in Patent Document 1, when the conductive particles sufficient to obtain stable electric continuity between facing circuit electrodes are contained in the anisotropic conductive adhesive composition, the insulating property between adjacent electrodes becomes insufficient, in the case where a bump area is less than 3000 µm². Furthermore, in a method where an entire surface of the conductive particles is coated with an insulating film like in Patent Document 2, although the insulating property between adjacent electrodes may be increased, the electric continuity between facing circuit electrodes tends to decrease, that is, there remains a space for improvement.

In the method where insulating particles coat a surface of conductive particle, an insulating resin such as acryl has to be used as the insulating particles so as to secure the adhesiveness between the insulating particles and conductive particles. Accordingly, at the time of thermal compression of the circuit, resinous insulating particles are melted to coat an entire surface of the conductive particles. As the result, similarly to a method where an entire surface of the conductive particles is coated with an insulating film, the electric continuity between facing circuit electrodes becomes insufficient.

On the other hand, in Patent Document 3, non-fusible insulating particles such as silica or titania are used as the insulating particles. However, in this case, the bonding force between the insulating particles and conductive particles is not sufficient, that is, there is a room to be further improved.

There is disclosed in Patent Document 4 a method where the insulating particles such as silica are modified with a functional group. However, it is generally difficult to modify the insulating particles having a particle diameter of 500 nm or less with a functional group. During a centrifugal separation or filtering applied after the insulating particles are modified with a functional group, the insulating particles tend to flocculate and the coating rate of the insulating particles are difficult to control.

The present invention has been achieved in view of problems of the existing technologies and intends to provide an anisotropic conductive adhesive film that is, in the connection of circuit electrodes having a narrow pitch and a narrow area, excellent in the insulating property between adjacent circuit electrodes on the same substrate and the electric continuity between facing circuit electrodes, an anisotropic conductive adhesive composition, coated particles used in the anisotropic conductive adhesive composition and a method for producing the same.

### Means for Solving the Problems

In order to achieve the above object, the invention provides a coated particle comprising a functional group-containing conductive particle at least partially surface-coated with an insulating material, wherein the conductive particle has a metal surface and at least a part of the metal surface has a functional group, and wherein the insulating material comprises polymer electrolytes and insulating particles made of an inorganic oxide having a hydroxy group on at least a part of a surface thereof.

This coated particle has characteristically less defects in the coating, and the insulating particles are not readily peeled off the coated particle. When these coated particles are dispersed in an insulating resinous composition, an anisotropic conductive adhesive composition excellent in insulating property between adjacent circuit electrodes and in electric continuity between facing circuit electrodes at the connection of circuits is obtained.

The present inventors assume the reason why such an effect is achieved is as follows. That is, both surface potentials (zeta potential) of a functional group-containing conductive particle having a functional group on a surface thereof and an insulating particle having a hydroxyl group on a surface thereof are usually minus when the pH is in a neutral region. However, a polymer electrolyte of which surface potential is plus is adsorbed on the surface of the functional group-containing conductive particle of the invention; accordingly, an electrostatic attractive force is generated between the functional group-containing conductive particle and the insulating particle. As the result, as the insulating particles uniformly coat, the insulating particles are firmly kept by the functional group-containing conductive particle. That is, what is mentioned above is considered one of the reasons why such an effect is obtained. Furthermore, also when the insulating particles are directly bonded to the surface of the functional group-containing conductive particle, chemical bonds such as covalent bond or hydrogen bond are formed between functional groups on the surface of the functional group-containing conductive particle and hydroxyl groups on the surface of the insulating particles, and thereby, the bond between the functional group-containing conductive particle and the insulating particles coating the surface of the conductive particles is strengthened. This is as well considered as one of reasons.

In the coated particle of the invention, a functional group on the surface of the functional group-containing conductive particle is preferably at least one selected from the group consisting of a hydroxyl group, a carboxyl group, an alkoxyl group and an alkoxycarbonyl group. Such functional groups tend to form a covalent bond or a hydrogen bond to the hydroxyl group on the surface of the insulating particles; accordingly, the bond between the functional group-containing conductive particle and the insulating particles coating the surface of the functional group-containing conductive particle is considered more strengthened.

In the coated particle of the invention, the functional group is preferably formed on the surface of the functional group-containing conductive particle by bringing a compound having at least one selected from the group consisting of a mercapto group, a sulfide group and a disulfide group into contact with the surface. Thereby, a functional group such as a hydroxyl group, a carboxyl group, an alkoxyl group or an alkoxycarbonyl group may be readily formed on the surface of the functional group-containing conductive particle.

In the coated particle of the invention, at least a part of functional groups on the surface of the functional group-containing conductive particle preferably binds chemically to at least a part of hydroxyl groups on the surface of the insulating particle. The coated particle having such chemical bond is large in the bonding force between the insulating particles and the functional group-containing conductive particle; accordingly, the insulating particles are not readily peeled off the surface of the functional group-containing conductive particle; as the result, an anisotropic conductive adhesive composition more excellent in the insulating property is considered obtained.

Furthermore, in the coated particle of the invention, a polymer electrolyte coating the functional group-containing conductive particle is preferably polyamine. In the case where the polymer electrolyte is polyamine, it is considered that an amino group in a molecule of the polymer electrolyte may bind strongly to the metal surface of the functional group-containing conductive particle. Still furthermore, the amino group not only readily binds to a metal surface of the functional group-containing conductive particle but also is high in the reactivity with a functional group on the surface of the functional group-containing conductive particle such as a carboxyl group. Accordingly, a bond between the functional group-containing conductive particle and the insulating particle coating the surface of the functional group-containing conductive particle is considered further strengthened.

In the coated particle of the invention, the polyamine is preferably polyethyleneimine. The polyethyleneimine, highest in the charge density of the polyamine, may strongly bind directly with the surface of the functional group-containing conductive particle. Accordingly, a bond between the functional group-containing conductive particle and the insulating particle coating the surface of the functional group-containing conductive particle is considered further strengthened.

In the coated particle of the invention, an insulating particle is preferred to be a silica particle. Thereby, a functional group-containing conductive particle may be more uniformly coated with an insulating material.

The invention provides a method for producing a coated particle comprising a functional group-containing conductive particle at least partially surface-coated with an insulating material comprising polymer electrolytes and insulating particles comprising: a functional group forming step where a compound having at least one selected from the group consisting of a mercapto group, a sulfide group and a disulfide group is brought into contact with a metal surface of a conductive particle to form a functional group on at least a part of the metal surface to obtain the functional group-containing conductive particle; and a coating step where the polymer electrolytes and the insulating particles made of an inorganic oxide having a hydroxyl group on at least a part of a surface thereof are brought into contact with at least a part of the surface of the functional group-containing conductive particle.

According to such producing method, the coated particle that is less in the coating defect and difficult to peel the insulating particles off the coated particle may be produced. When coated particles like this are dispersed in an insulating resinous composition, an anisotropic conductive adhesive composition excellent, at the time of circuit connection, in the insulating property between adjacent circuit electrodes and in the electric continuity between facing circuit electrodes may be obtained.

Furthermore, in the method for producing the coated particle of the invention, the coating step is preferably a step where the polymer electrolytes are brought into contact with at least a part of the surface of the functional group-containing conductive particle, followed by bringing the insulating particles into contact. According to such a producing method, the coated particle that is further less in the coating defect and difficult to peel the insulating particles off the coated particle may be produced.

In the method for producing the coated particle of the invention, a functional group on the surface of the functional group-containing conductive particle is preferably at least one selected from the group consisting of a hydroxyl group, a carboxyl group, an alkoxyl group and an alkoxycarbonyl group. Such a functional group tends to form a covalent bond or a hydrogen bond to the hydroxyl group on the surface of the insulating particle; accordingly, the bond between the functional group-containing conductive particle and the insulating particle is considered more strengthened. Accordingly, a coated particle where insulating particles are not readily peeled off the functional group-containing conductive particle can be obtained.

In the method for producing the coated particle of the invention, at least a part of functional groups of the coated particle binds chemically to at least a part of hydroxyl groups on the surface of the insulating particle. The coated particle having such chemical bond is large in the bonding force between the insulating particles and the functional group-containing conductive particle, and the insulating particles do not readily peel off the coated particle; accordingly, an anisotropic conductive adhesive composition more excellent in the insulating property is considered obtained.

Furthermore, in the method for producing the coated particle of the invention, a polymer electrolyte is preferably polyamine. In the case where the polymer electrolyte is polyamine, it is considered that an amino group in a molecule of the polymer electrolyte may bind strongly to the metal surface of the functional group-containing conductive particle. Still furthermore, the amino group not only readily binds to the metal surface of the functional group-containing conductive particle but also is high in the reactivity with a functional group on the surface of the functional group-containing conductive particle such as a carboxyl group. Accordingly, a coated particle further stronger in a bond between the functional group-containing conductive particle and the insulating particles coating the surface of the functional group-containing conductive particle is considered obtained.

In the method for producing the coated particle of the invention, the polyamine is preferably polyethyleneimine. The polyethyleneimine, highest in the charge density of the polyamine, may strongly bind to the surface of the functional group-containing conductive particle. Accordingly, a coated particle stronger in a bond between the functional group-containing conductive particle and the insulating particles coating a surface of the functional group-containing conductive particle is considered obtained.

In the method for producing the coated particle of the invention, an insulating particle is preferred to be a silica particle. Thereby, coated particles more uniformly coated with an insulating material may be produced.

The invention further provides an anisotropic conductive adhesive composition containing the coated particles and insulating resin composition. In the anisotropic conductive adhesive composition, the coated particles exerting above-effects are dispersed in the resin composition; accordingly, during circuit connection, the insulating property between adjacent circuit electrodes and the electric continuity between the facing circuit electrodes are excellent.

The invention further provides an anisotropic conductive adhesive film obtained by forming the anisotropic conductive adhesive composition into film. In the anisotropic conductive adhesive film, an anisotropic conductive adhesive composition, that is, the coated particles exerting the effects are dispersed in a resin composition is formed into film; accordingly, during circuit connection, the insulating property between adjacent circuit electrodes and the electric continuity between the facing circuit electrodes are excellent.

### Effect of the Invention

According to the present invention, an anisotropic conductive adhesive film excellent in the insulating property between adjacent circuit electrodes on the same substrate and in the electric continuity between facing circuit electrodes at the time of connection of circuit electrodes having a narrow pitch and a narrow area, an anisotropic conductive adhesive composition, a coated particle used in the anisotropic conductive adhesive composition and a method for producing the same are provided.

### Brief Description of the Drawings

Figure 1 is an outline view of a coated particle according to one embodiment of the invention;
Figure 2 is a sectional view of an anisotropic conductive adhesive film according to one embodiment of the invention;
Figure 3 is a sectional view showing a method for producing a circuit-connecting material that is connected with an anisotropic conductive adhesive film according to one embodiment of the invention; and
Figure 4 is a sectional view showing a circuit-connecting material that is connected with an anisotropic conductive adhesive film according to one embodiment of the invention.

### Explanation of Symbols

4 : polymer electrolyte, 6 : insulating particle, 8 : functional group-containing conductive particle, 10 : coated particle, 12 : resin composition, 20 : first circuit member, 21 : first substrate, 21a : first substrate surface, 22 : first circuit electrode, 30 : second circuit member, 31 : second substrate, 31a : second substrate surface, 32 : second circuit electrode.

### Best Mode for Carrying Out the Invention

In what follows, preferable embodiments of the invention will be described with reference to drawings as required. In the explanation of the drawings, same or similar elements are explained with the same reference numerals and explanations thereof will be omitted.

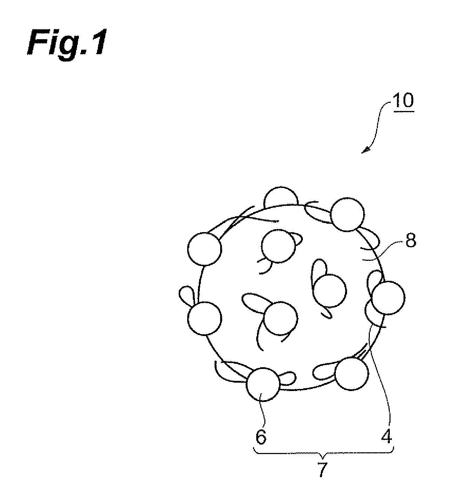

Figure 1 is an outline view of a coated particle according to a first embodiment of the invention. A coated particle 10 according to the present embodiment is constituted of a functional group-containing conductive particle 8 having a functional group partially on an conductive metal surface and insulating materials 7 containing polymer electrolytes 4 and insulating particles 6 coating the surface of the functional group-containing conductive particle 8.

The polymer electrolytes 4 are adsorbed on the surface of the functional group-containing conductive particle 8 and at least a part of the insulating particles 6 coat the functional group-containing conductive particle 8 through the polymer electrolytes 4. At least a part of the insulating particles 6 may directly bind to the functional group-containing conductive particle 8 without intervention of the polymer electrolytes 4.

A particle diameter of the functional group-containing conductive particle 8 is necessarily smaller than the minimum separation between electrodes adjacent to each other on the same substrate from the viewpoint of securing the insulating property. Furthermore, a particle diameter of the functional group-containing conductive particle 8, when electrodes have the dispersion in height on the same substrate, is preferably larger than the dispersion thereof. From such the viewpoint, a particle diameter of the functional group-containing conductive particle 8 is preferably in the range of 1 to 10 µm and more preferably in the range of 2.5 to 5 µm.

The functional group-containing conductive particle 8 is preferred to contain a core particle made of an organic material inside of a metal layer disposed at the outermost layer from the viewpoint of increasing a contact area with an electrode owing to deformation under heating and pressure. A material of the core particle is not particularly restricted. Examples thereof include acrylic resin such as polymethyl methacrylate or polymethyl acrylate and a polyolefin resin such as polyethylene, polypropylene, polyisobutylene or polybutadiene.

In the metal layer disposed at the outermost layer of the functional group-containing conductive particle 8, a metal such as gold, silver, copper, platinum, zinc, iron, palladium, nickel, tin, chromium, titanium, aluminum, cobalt, germanium or cadmium, or ITO or solder may be used.

A thickness of the metal layer is not particularly restricted. However, the thickness is preferably in the range of 0.005 to 1.0 µm and more preferably in the range of 0.01 to 0.3 µm. When the thickness of the metal layer is less than 0.005 µm, the electric continuity failure tends to occur. On the other hand, when the thickness of the metal layer exceeds 1.0 µm, the cost disadvantageously goes up.

The functional group-containing conductive particle 8 may be formed by coating a core particle with a metal by plating. Examples of method of coating a core particle with a metal layer include electroless plating, immersion plating, electroplating and sputtering. The metal layer may be formed into a single layer structure or a laminated structure made of a plurality of layers. In the case of the laminated structure, gold coating is preferably applied to the outermost layer from the viewpoint of the corrosion resistance and electric continuity.

The functional group-containing conductive particle 8 may have a structure entirely made of metal or a metal compound by forming the core particle from metal.

The functional group-containing conductive particle 8 has a functional group on a surface thereof. The functional group is preferably at least one selected from a hydroxyl group, a carboxyl group, an alkoxyl group and an alkoxycarbonyl group from the viewpoint of improving the bonding force with an insulating particle. That the functional groups are formed on the surface of the functional group-containing conductive particle 8 may be confirmed by an analysis method such as X-ray electron spectroscopy or time-of-flight secondary ion mass spectrometry.

The functional groups may be formed by bringing a compound forming a covalent bond into contact with the surface of the functional group-containing conductive particle 8. In the case where the surface of the functional group-containing conductive particle 8 is for instance gold, a compound having at least one selected from the group consisting of a mercapto group, a sulfide group and a disulfide group, all of which are capable of forming a coordinate bond with gold, is brought into contact with the surface of the functional group-containing conductive particle 8, thereby at least one functional group selected from the group consisting of a hydroxyl group, a carboxyl group, an alkoxyl group and an alkoxycarbonyl group may be formed on the surface of the functional group-containing conductive particle 8. Examples of compound having at least one functional group selected from the group consisting of a mercapto group, a sulfide group and a disulfide group include mercaptoacetic acid, 2-mercaptoethanol, methyl mercaptoacetate, mercaptosuccinic acid, thioglycerin and cysteine.

As a specific method for forming the functional group on the surface of the functional group-containing conductive particle 8, for instance, a method where the foregoing compound such as mercaptoacetic acid is dissolved by substantially 10 to 100 mmol/L in an organic solvent such as methanol or ethanol, followed by dispersing the functional group-containing conductive particles 8 in the solution is cited.

The functional group-containing conductive particle 8 has polymer electrolytes 4 on a surface thereof. The polymer electrolytes 4 are electrostatically adsorbed by the surface of the functional group-containing conductive particle 8. When the functional group-containing conductive particle 8 has polymer electrolytes 4 on a surface thereof, the functional group-containing conductive particle 8 may be coated uniformly with the insulating particles 6. This is because the surface potential (zeta potential) of the functional group-containing conductive particle 8 having a hydroxyl group, a carboxyl group, an alkoxyl group or an alkoxycarbonyl group, which is usually minus in a dispersion of which pH is neutral, becomes plus owing to the possession of the polymer electrolyte 4 on the surface. Thereby, the insulating particles 6 of which surface potential is usually minus become readily capable of coating the functional group-containing conductive particle 8 via the polymer electrolytes 4; as the result, a coated particle 10 uniformly coated with the insulating particles 6 can be obtained.

The insulating particle 6 may, without intervening the polymer electrolyte 4, directly bind to the functional group-containing conductive particle 8 to be capable of coating the functional group-containing conductive particle 8. However, when the functional group-containing conductive particle 8 is coated via the polymer electrolyte 4 as mentioned above, the effect can be obtained that the surface of the functional group-containing conductive particle 8 is more uniformly coated and the insulating particles 6 do not readily peel off the coated particle 10.

As the polymer electrolyte 4, those that are soluble in water or a mixed solvent of water and water-soluble organic solvent and ionized in an aqueous solution, and have a charged functional group in a main chain or a side chain may be used, among these polycation being preferred. As the polycation, those having a functional group capable of charging plus like polyamine, such as any one of polyethyleneimine (PEI), polyallyamine hydrochloride (PAH), polydiallyldimethylammonium chloride (PDDA), polyvinyl pyridine (PVP), polylysine, and polyacrylamide or copolymers containing at least one of the polycations may be used. That the polymer electrolytes are adsorbed on the surface of the functional group-containing conductive particle 8 may be confirmed by an analysis method such as X-ray electron spectroscopy or time-of-flight secondary ion mass spectrometry.

Among the polycations, polyethyleneimine is preferably used because it is high in the charge density and strong in the bonding force with the functional group-containing conductive particle. A weight average molecular weight of the polymer electrolyte varies depending on the kind of the polymer electrolyte used and is not uniquely determined. However, the molecular weight is generally preferred to be substantially from 500 to 200,000 from the viewpoint of improving the water solubility and adsorption amount to the functional group-containing conductive particle and from the viewpoint of easy handling.

As a method of adsorbing the polymer electrolytes 4 on the surface of the functional group-containing conductive particle 8, for instance a method where the functional group-containing conductive particles 8 are immersed in a polymer electrolyte solution obtained by dissolving the polymer electrolytes 4 in water or a mixed solvent obtained by mixing water and a water-soluble organic solvent is cited. In this case, a concentration of the polymer electrolyte 4 in a polymer electrolyte solution is usually preferably substantially from 0.01 to 10% by mass from the viewpoint of improving the water solubility and adsorption amount to the functional group-containing conductive particle and from the viewpoint of easy handling. The pH of the polymer electrolyte solution is not particularly restricted.

Examples of water-soluble organic solvent include, for example, methanol, ethanol, propanol, acetone, dimethylformamide and acetonitrile. The polymer electrolyte solution is preferred not to contain alkali metal (Li, Na, K, Rb, Cs) ions, alkaline earth metal (Ca, Sr, Ba, Ra) ions and halogenide ions (fluoride ion, chloride ion, bromide ion, iodide ion) so as to avoid electromigration and corrosion.

A ratio of the surface of the functional group-containing conductive particle 8 coated by the insulating particles 6, that is, a coating rate may be controlled by controlling the kind, molecular weight and concentration of the polymer electrolyte 4 adsorbed on the surface of the functional group-containing conductive particle 8.

Specifically, in the case where the polymer electrolyte 4 high in the charge density such as polyethyleneimine is used, the coating rate of the insulating particles 6 tends to be higher, and in the case where the polymer electrolyte 4 low in the charge density such as polydiallyldimethylammonium chloride is used, the coating rate tends to be smaller. Furthermore, when a molecular weight of the polymer electrolyte 4 is large, the coating rate tends to be higher and when a molecular weight of the polymer electrolyte 4 is small, the coating rate tends to be lower. Still furthermore, when the polymer electrolyte 4 is used at a high concentration, the coating rate tends to be higher and when the polymer electrolyte 4 is used at a low concentration, the coating rate tends to be lower.

When the coating rate is high, the insulating property between circuit electrodes adjacent on the same substrate tends to be higher and the electric continuity between facing circuit electrodes tends to be deteriorated, and when the coating rate is low, the electric continuity tends to be higher and the insulating property tends to be lower.

The insulating particle 6 is preferred to be fine particles made of inorganic oxide from the viewpoint of making the electric continuity between facing circuit electrodes sufficiently high. As the fine particles of inorganic oxide, fine particles made of oxide containing at least one element selected from silicon, aluminum, zirconium, titanium, niobium, zinc, tin, cerium and magnesium may be preferably used. These may be used singularly or in a combination of at least two kinds thereof.

Among the fine particles of inorganic oxide, water-dispersed colloidal silica (SiO₂) of which particle diameter is controlled is particularly preferred from the viewpoint of improving the insulating properties. Furthermore, the water-dispersed colloidal silica has hydroxyl groups on a surface thereof and thereby has advantages of being excellent in the bonding force with the functional group-containing conductive particle 8, easy in controlling the particle diameter and less expensive. As the commercially available water-dispersed colloidal silica, for example, SNOWTEX and SNOWTEX UP (trade name, manufactured by Nissan Chemical Industries, Ltd.) and QUARTRON PL SERIES (trade name, manufactured by Fuso Chemical Co., Ltd.) may be preferably used.

The insulating particle 6 has hydroxyl groups on at least a part of a surface thereof. The hydroxyl groups may be partially modified with a silane coupling agent into amino groups, carboxyl groups or epoxy groups. Usually, it is difficult to modify the inorganic oxide when a particle diameter thereof is 500 nm or less; accordingly, in this case, without modifying, the functional group-containing conductive particle 8 is preferably coated.

In general, a hydroxyl group undergoes a dehydration condensation reaction with a functional group such as a hydroxyl group, a carboxyl group, an alkoxyl group or an alkoxycarbonyl group to form strong bond owing to a covalent bond or a hydrogen bond. Accordingly, when the functional group-containing conductive particle 8 has these functional groups on a surface thereof, the bonding force between the functional group-containing conductive particle 8 and the insulating particles 6 may be improved.

A total concentration of alkali metal ions and alkaline earth metal ions in a dispersion solution where the insulating particles 6 are dispersed is preferably 100 ppm or less from the viewpoint of the insulation reliability of the resulted anisotropic conductive adhesive. Fine particles made of the inorganic oxide are preferably produced according to a hydrolysis reaction, that is, a so-called sol-gel method of a metal alkoxide.

A particle diameter of the insulating particles 6 is preferably from 20 to 500 nm. When the particle diameter is less than 20 nm, the insulating particles 6 that coat the functional group-containing conductive particle 8 do not work as an insulating layer; as the result, the circuit electrodes adjacent to each other on the same substrate may not be sufficiently inhibited from causing short-circuiting. On the other hand, when the particle diameter exceeds 500 nm, the electric continuity between facing circuit electrodes tends to be deteriorated. The particle diameter may be measured by a specific area calculation method according to a BET method or an X-ray small angle scattering method.

The insulating particles 6 are preferred to coat the surface of the functional group-containing conductive particle 8 in a single layer. When a plurality of layers of the insulating particles 6 are formed on the surface of the functional group-containing conductive particle 8, a stacking amount of the insulating particles 6 tends to be difficult to control. The coating rate of the surface of the functional group-containing conductive particle 8 by the insulating particles 6 is preferably from 20 to 100%. Herein, 100% means a case where, when the surface of the functional group-containing conductive particle 8 is expanded as a plane, the plane is most closely packed with the insulating particles 6.

The coated particle 10 according to the present embodiment may be obtained by adsorbing the polymer electrolytes 4 on the surface of the functional group-containing conductive particle 8, followed by coating with the insulating particles 6.

In general, such a method is called a layer-by-layer assembly method. The layer-by-layer assembly method is a method for forming an organic thin film, which was disclosed by G. Decher et al. in 1992 (Thin Solid Films, 210/211, 1992, p. 831). According to the method, a base material is alternately immersed in an aqueous solution of a polymer electrolyte having positive charge (polycation) and an aqueous solution of a polymer electrolyte having negative charge (polyanion), and thereby combinations of the polycation and polyanion adsorbed by electrostatic attractive force are stacked on a substrate to form a composite film (layer-by-layer assembled film).

In the layer-by-layer assembly method, charges of a material formed on the base material and a material having opposite charge in the solution electrostatically attract each other to grow a film; accordingly, when the adsorption proceeds and charges are neutralized, the adsorption does not proceed more than that. Accordingly, when a saturation point is achieved, the film thickness does not increase more than that.

Furthermore, Lvov et al. applies the layer-by-layer assembly method to fine particles and report a method where with a dispersion liquid of each of fine particles of silica, titania and ceria, a polymer electrolyte having charges opposite to the surface charges of the fine particles is layered according to the layer-by-layer assembly method (Langmuir, Vol. 13, 1997, p. 6195 - 6203, Non-Patent Document 1). According to the method, a fine particle-layered thin film where silica fine particles and polymer electrolytes are alternately layered is formed by alternately layering silica fine particles having negative surface charge and a polycation having charge opposite to that of the silica fine particles, that is, polydiallyldimethyl ammonium chloride (PDDA) or polyethyleneimine (PEI).

As a method for producing the coated particle 10, a following producing method is cited. The producing method includes: a step of forming a functional group where a compound having at least one selected from the group consisting of a mercapto group, a sulfide group and a disulfide group is brought into contact with a surface of an conductive particle to form functional groups partially on the surface to obtain a functional group-containing conductive particle 8; and a step of coating where polymer electrolytes 4 and insulating particles 6 made of an inorganic oxide having a hydroxyl group on at least a part of a surface thereof are brought into contact with at least a part of the surface of the functional group-containing conductive particle 8.

The step of coating of the method for producing the coated particle 10 may be divided into a step of bringing the polymer electrolytes 4 into contact with at least a part of the surface of the functional group-containing conductive particle 8 and, thereafter, a step of bringing insulating particles made of a polymer electrolyte and an inorganic oxide having a hydroxyl group into contact with at least a part of the surface of the functional group-containing conductive particle 8. Furthermore, the step of coating may have a step of washing superfluous polymer electrolytes 4 that are not adsorbed on the surface of the functional group-containing conductive particle 8 after the step of bringing the polymer electrolytes 4 into contact with at least a part of the surface of the functional group-containing conductive particle 8, and a step of washing superfluous insulating particles 6 that do not coat the functional group-containing conductive particle 8 after the step of bringing the insulating particles 6 into contact with the surface of the functional group-containing conductive particle 8.

Examples of the washing solvent that is used to wash the superfluous polymer electrolytes and insulating particles include water, alcohol and acetone. It is preferred to use ion exchanged water (so-called ultrapure water) having a specific resistance value of 18 MΩ·cm or more for washing from the viewpoint of sufficiently removing the superfluous polymer electrolytes 4 or superfluous insulating particles 6. The polymer electrolytes 4 adsorbed on the surface of the functional group-containing conductive particle 8 and/or the insulating particles 6 bonded directly or via the polymer electrolytes 4 to the surface of the functional group-containing conductive particle 8 are not usually peeled off in the step of washing the superfluous polymer electrolytes 4 and the superfluous insulating particles 6.

When the step of washing the superfluous polymer electrolytes 4 and the step of washing the superfluous insulating particles 6 are applied, the polymer electrolyte solution is inhibited from containing the insulating particles 6, and a dispersion liquid of the insulating particles 6 is inhibited from containing the polymer electrolytes 4. When cations and anions are mixed in the dispersion liquid of the insulating particles and in the polymer electrolyte solution caused by contamination, the polymer electrolytes and insulating particles may flocculate or precipitate.

When thus prepared coated particle 10 is heated and dried, the bonding force between the insulating particles 6 and the functional group-containing conductive particle 8 may be further strengthened. This is because a chemical bond is newly formed between functional groups such as carboxyl groups or the like on the surface of the functional group-containing conductive particle 8 and hydroxyl groups on a surface of the insulating particle 6. The coated particles 10 are preferably heated and dried at a temperature from 60 to 200°C for 10 to 180 min. When the temperature is lower than 60°C or the heating time is shorter than 10 min, the insulating particles 6 tend to be readily peeled off the surface of the functional group-containing conductive particle 8. On the other hand, when the temperature is higher than 200°C or the heating time is longer than 180 min, the functional group-containing conductive particle 8 tends to deform.

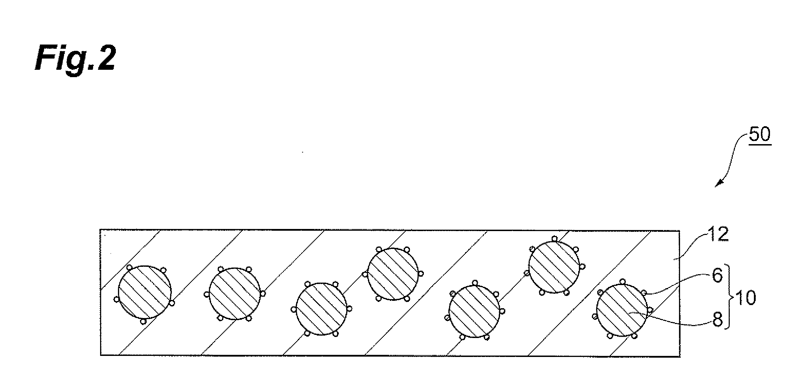

Figure 2 is a sectional view showing an anisotropic conductive adhesive film according to one embodiment of the invention. An anisotropic conductive adhesive film 50 of the embodiment is obtained by forming a film from an anisotropic conductive adhesive composition where the coated particles 10 prepared as mentioned above are dispersed in an insulating resin composition 12. In Figure 2, the polymer electrolytes 4 adsorbed on the surface of the functional group-containing conductive particle 8 are not shown in the drawing for the sake of convenience of description.

As the resin composition 12 used in the anisotropic conductive adhesive composition according to the embodiment, a mixture of a heat-reactive resin and a curing agent may be used. Among these, a mixture of an epoxy resin and a latent curing agent is preferably used. Examples of the latent curing agent include imidazole, hydrazide, boron trifluoride-amine complex, sulfonium salt, amineimide, polyamine salt and dicyandiamide and the like. As another embodiment of the invention, a mixture of a radical reactive resin and an organic peroxide or a resin curable with energy rays such as UV ray may be used in the resin composition 12.

As the epoxy resin, bisphenol epoxy resins derived from epichlorhydrine and bisphenol A, bisphenol F or bisphenol AD; epoxy novolak resins derived from epichlorhydrine and phenol novolak or cresol novolak; naphthalene epoxy resins having a skeleton containing a naphthalene ring; and various kinds of epoxy compounds having at least two glycidyl groups in one molecule such as glycidyl amine, glycidyl ether, biphenyl, alicyclic or the like may be used singularly or in a combination of at least two kinds thereof. As the epoxy resin, a high purity product where impurity ions (Na⁺, Cl⁻ and so on), hydrolysable chlorine and so on are reduced to 300 ppm or less is preferably used from the viewpoint of preventing an electromigration.

To the resin composition 12, in addition to the above-mentioned components, butadiene rubber, acryl rubber, styrene-butadiene rubber, silicone rubber or the like may be mixed to reduce the stress after circuit adhesion or to improve the adhesiveness.

In the anisotropic conductive adhesive composition, a thermoplastic resin (film forming polymer) such as a phenoxy resin, a polyester resin, a polyamide resin or the like may be preferably blended in the resin composition 12 from the viewpoint of the film forming property. When the film forming polymer is blended, the stress is preferably alleviated at the time of curing of the reactive resin. Furthermore, the film forming polymer is preferred to have a functional group such as a hydroxyl group or the like from the viewpoint of improving the adhesiveness. The anisotropic conductive adhesive composition may be formed in paste.

A film is formed in such a manner that a resin composition 12 containing an epoxy resin, acryl rubber and a latent curing agent is dissolved or dispersed in an organic solvent to be liquefied, coated particles 10 are added thereto and dispersed, followed by coating on a peelable base material, further followed by removing the solvent at an activation temperature or less of the curing agent. As the organic solvent, a mixed solvent of an aromatic hydrocarbon solvent and an oxygen-containing solvent is preferred from the viewpoint of improving the solubility of the resin composition 12.

A ratio of the coated particles 10 in the anisotropic conductive adhesive composition is preferably from 0.1 to 30% by volume and more preferably from 1 to 25% by volume based on an entirety of the anisotropic conductive adhesive composition from the viewpoint of improving the insulating property between adjacent electrodes and the electric continuity between facing electrodes.

A thickness of the anisotropic conductive adhesive film 50 is determined relatively by considering the particle diameter of the coated particle 10 and the property of the anisotropic conductive adhesive composition, and is preferred to be from 1 to 100 µm and more preferred to be from 3 to 50 µm. When the thickness of the anisotropic conductive adhesive film 50 is 1 µm or less, sufficient adhesiveness may not be obtained. On the other hand, when the thickness is 100 µm or more, many coated particles 10 are necessary to obtain the electric continuity between facing circuit electrodes, that is, this case is not practical.

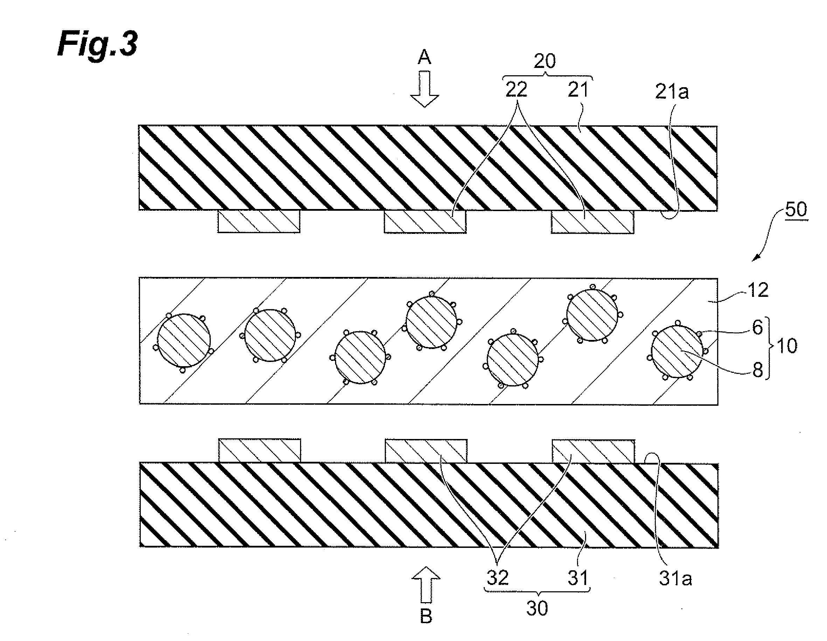

Figure 3 is a sectional view showing a method for producing a circuit-connecting material connected with an anisotropic conductive adhesive film according to one embodiment of the invention. In Figure 3, the polymer electrolytes 4 adsorbed on the surface of the functional group-containing conductive particle 8 are not shown for the sake of convenience of description.

A first circuit member has a first electrode 22 on a surface 21a of a first substrate 21. A second circuit member has a second electrode 32 on a surface 31a of a second substrate 31. As the substrate herein, a glass substrate, a tape substrate such as polyimide or the like, a bare chip such as driver IC or the like, a rigid package substrate or the like are cited.

The above-mentioned anisotropic conductive adhesive film 50 is interposed between the first circuit member 20 and the second circuit member 30. At this time, the first circuit member 20 and second circuit member 30 are disposed so that the first circuit electrode 22 and the second circuit electrode 32 may face each other.

In the next place, as heating the anisotropic conductive adhesive film 50 through the circuit member 20 and circuit member 30, pressure is applied in a direction of an arrow mark A and an arrow mark B in Figure 3 to form a circuit-connecting material. The curing process may be applied according to a general method such as UV irradiation or heating and the method is appropriately selected depending on the resin composition 12.

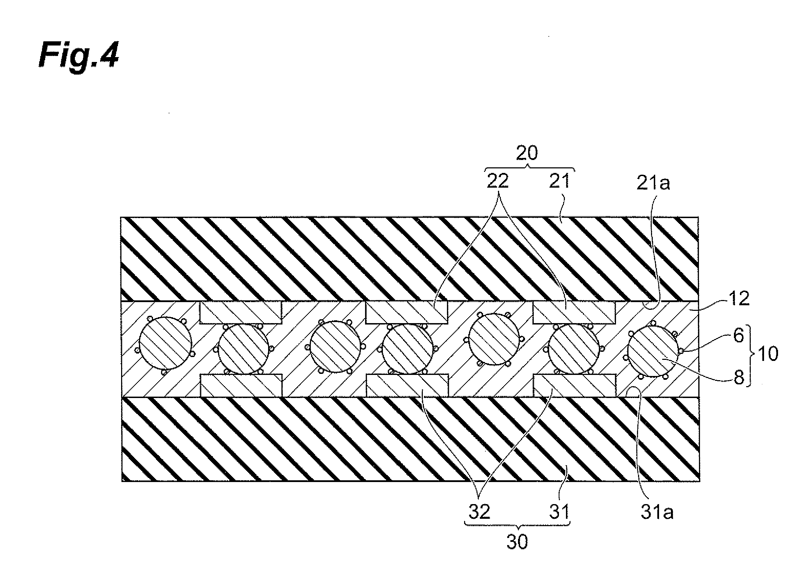

Figure 4 is a sectional view of a circuit-connecting material connected with the anisotropic conductive adhesive film according to one embodiment of the invention. Thus connected circuit-connecting material is excellent in the electric continuity between the circuit electrode 22 and circuit electrode 32 that face each other and the insulating property between the circuit electrodes 22 and circuit electrodes 32, respectively, adjacent on the same substrate. In Figure 4, the polymer electrolytes 4 adsorbed on the surface of the functional group-containing conductive particle 8 are not shown for the sake of convenience of description.

In what was described above, preferable embodiments of the invention were described. However, the invention is not at all restricted to the embodiments.

### Examples

In what follows, the invention will be more specifically described with reference to examples and comparative examples. However, the invention is not at all restricted to examples shown below.

### (Conductive particles 1)

A nickel layer having a thickness of 0.2 µm was formed by means of electroless plating on a surface of crosslinked polystyrene particles having an average particle diameter of 3.5 µm. On an outer surface of thus formed nickel layer, a gold layer having a thickness of 0.04 µm was further formed by means of electroless plating, and thereby conductive particles 1 were prepared.

### (Coated particle 1)

### <Step of forming functional group>

In the beginning, 8 mmol of MERCAPTOACETIC ACID (trade name, manufactured by Wako Pure Chemical Industries, Ltd.) was dissolved in 200 ml of methanol, followed by adding 1 g of the conductive particles 1, further followed by agitating at room temperature (25°C) for 2 hr with a Three One Motor (trade name: BL3000, manufactured by Shinto Scientific Co., Ltd.) provided with an agitating blade having a diameter of 45 mm, followed by filtering with a methanol-cleansed membrane filter of φ3 µm (trade name: FSLW 04700, manufactured by Millipore), and thereby 1 g of functional group-containing conductive particles having a carboxyl group on a surface thereof was obtained.

### <Step of adsorbing polymer electrolytes>

In the next place, a 30% by mass aqueous solution of polyethyleneimine having a weight average molecular weight of 70000 (trade name: 30% POLYETHYLENEIMINE P-70 SOLUTION, manufactured by Wako Pure Chemical Industries, Ltd.) was diluted with ultrapure water and thereby a 0.3% by mass aqueous solution of polyethyleneimine was obtained. To the 0.3% by mass aqueous solution of polyethyleneimine, 1 g of the above-mentioned functional group-containing conductive particles was added, followed by agitating at room temperature (25 °C) for 15 min, further followed by filtering with a membrane filter of φ3 µm (trade name: SSWP 04700, manufactured by Millipore), and particles (mother particles) having the polymer electrolytes adsorbed on a surface thereof were obtained. The mother particles were mixed in 200 g of ultrapure water, followed by agitating at room temperature (25°C) for 5 min, further followed by filtering with a membrane filter of φ3 µm (trade name: SSWP 04700, manufactured by Millipore), and particles obtained by filtering were washed twice on the membrane filter with 200 g of ultrapure water to remove polyethyleneimine that is not adsorbed by the mother particles.

### <Step of coating with insulating particles>

After removal of polyethyleneimine, 1 g of the mother particles was mixed in 0.1% by mass silica dispersion obtained by diluting colloidal silica dispersion (product name: QUARTRON PL-13, manufactured by Fuso Chemical Co., Ltd., concentration: 20% by mass, average particle diameter: 130 nm) with ultrapure water, followed by agitating at room temperature (25°C) for 15 min, further followed by filtering with a membrane filter of φ3 µm (trade name: SSWP 04700, manufactured by Millipore). After filtration, the mother particles were mixed in 200 g of ultrapure water and agitated at room temperature (25°C) for 5 min, followed by filtering with a membrane filter of φ3 µm (trade name: SSWP 04700, manufactured by Millipore), and the mother particles were washed twice on the membrane filter with 200 g of ultrapure water to remove superfluous silica. Thereafter, the mother particles were dried at 80°C for 30 min, then, heated and dried under conditions of at 120°C for 1 hr, thereby coated particles 1 were obtained.

### (Coated particle 2)

Coated particles 2 were obtained in a manner similar to the coated particles 1 except that a 30% by mass aqueous solution of polyethyleneimine having a weight average molecular weight of 10000 (trade name, manufactured by Wako Pure Chemical Industries, Ltd.) was used in place of a 30% by mass aqueous solution of polyethyleneimine having an average molecular weight of 70000.

### (Coated particle 3)

Coated particles 3 were obtained in a manner similar to the coated particles 1 except that a 30% by mass aqueous solution of polyethyleneimine having a weight average molecular weight of 600 (trade name, manufactured by Wako Pure Chemical Industries, Ltd.) was used in place of a 30% by mass aqueous solution of polyethyleneimine having an average molecular weight of 70000.

### (Coated particle 4)

Coated particles 4 were obtained in a manner similar to the coated particles 1 except that a 0.3% by mass aqueous solution of polydiallyldimethylammonium chloride obtained by diluting a 20% by mass aqueous solution of polydiallyldimethylammonium chloride having a weight average molecular weight from 100000 to 200000 (trade name, manufactured by Aldrich) with ultrapure water was used in place of a 0.3% by mass aqueous solution of polyethyleneimine obtained by diluting a 30% by mass aqueous solution of polyethyleneimine having a weight average molecular weight of 70000 with ultrapure water.

### (Coated particle 5)

Coated particles 5 were obtained in a manner similar to the coated particle 1 except that a 0.3% by mass aqueous solution of polyallylamine hydrochloride obtained by diluting polyallylamine hydrochloride having a weight average molecular weight of 70000 (trade name, manufactured by Aldrich) with ultrapure water was used in place of a 0.3% by mass aqueous solution of polyethyleneimine obtained by diluting a 30% by mass aqueous solution of polyethyleneimine having a weight average molecular weight of 70000 with ultrapure water.

### (Coated particle 6)

Coated particles 6 were obtained in a manner similar to the coated particles 1 except that ethyl mercaptoacetate (trade name, manufactured by Wako Pure Chemical Industries, Ltd.) was used in place of mercaptoacetic acid.

### (Coated particle 7)

Coated particles 7 were obtained in a manner similar to the coated particles 1 except that 2-mercaptoethanol (trade name, manufactured by Wako Pure Chemical Industries, Ltd.) was used in place of mercaptoacetic acid.

### (Coated particle 8)

Coated particles 8 were obtained in a manner similar to the coated particles 1 except that the step of forming functional group was not applied.

### (Coated particle 9)

Coated particles 9 were obtained in a manner similar to the coated particles 1 except that the step of adsorbing polymer electrolytes was not applied.

### (Example 1)

In the beginning, 100 g of a phenoxy resin (product name: PKHC, manufactured by Union Carbide Corporation) and 75 g of acryl rubber (copolymer of 40 parts by mass butyl acrylate, 30 parts by mass ethyl acrylate, 30 parts by mass acrylonitrile and 3 parts by mass glycidyl methacrylate, weight average molecular weight: 850000) were dissolved in 400g ethyl acetate, thereby a solution having a polymer concentration of 30% by mass was obtained. To the solution, 300 g of liquid epoxy (product name: NOVACURE HX-3941, manufactured by Asahi Kasei Epoxy Co., Ltd., epoxy equivalent: 185) containing microcapsule type latent curing agent was added and agitated, thereby a resin composition solution was prepared.

A dispersion liquid (content of the coated particles 1 based on the anisotropic conductive adhesive agent: 9% by volume) was prepared by mixing 20 g of the coated particles 1 in 100 g of the resin composition solution. The dispersion liquid was coated on a separator (thickness: 40 µm) that is a silicone-treated polyethylene terephthalate film, dried at 90°C for 10 min, thereby an anisotropic conductive adhesive film having a thickness of 25 µm was prepared.

A chip (1.7 mm × 17 mm, thickness: 0.5 mm) with gold bumps (area: 30 µm × 90 µm, space: 10 µm, height: 15 µm, bump number: 362) and a glass substrate with Al circuits (manufactured by Geomatec Co., Ltd., thickness: 0.7 mm) were connected with the prepared anisotropic conductive adhesive film as shown below.

With a surface on a side opposite to a surface where a separator of the anisotropic conductive adhesive film is disposed directed to a surface where an Al circuit of the glass substrate with Al circuit is formed, the anisotropic conductive adhesive film cut into a predetermined size (2 mm × 19 mm) was bonded onto a surface of the glass substrate with an Al circuit at 80°C under 0.98 MPa (10 kgf/cm²). Thereafter, the separator was peeled off the anisotropic conductive adhesive film bonded to the glass substrate provided with a Al circuit, followed by carrying out positional alignment of the gold bumps of the chip and the glass substrate provided with an Al circuit via the anisotropic conductive adhesive film. Then, a surface where gold bumps of the chip were disposed was directed to a surface that was the opposite side surface to the surface attached to the glass substrate provided with an Al circuit of the anisotropic conductive adhesive film, and is bonded on the anisotropic conductive adhesive film, a connection operation was applied by heating and pressurizing under conditions of 190°C, 40 g/bump and 10 sec, and thereby a connecting material sample was obtained.

### (Example 2)

A connecting material sample was obtained in a manner similar to example 1 except that the coated particles 2 were used in place of the coated particles 1.

### (Example 3)

A connecting material sample was prepared in a manner similar to example 1 except that the coated particles 3 were used in place of the coated particles 1.

### (Example 4)

A connecting material sample was prepared in a manner similar to example 1 except that the coated particles 4 were used in place of the coated particles 1.

### (Example 5)

A connecting material sample was prepared in a manner similar to example 1 except that the coated particles 5 were used in place of the coated particles 1.

### (Example 6)

A connecting material sample was prepared in a manner similar to example 1 except that the coated particles 6 were used in place of the coated particles 1.

### (Example 7)

A connecting material sample was prepared in a manner similar to example 1 except that the coated particles 7 were used in place of the coated particles 1.

### (Comparative Example 1)

A connecting material sample was prepared in a manner similar to example 1 except that the conductive particles 1 were used in place of the coated particles 1.

### (Comparative Example 2)

A connecting material sample was prepared in a manner similar to example 1 except that the coated particles 8 were used in place of the coated particles 1.

### (Comparative Example 3)

A connecting material sample was prepared in a manner similar to example 1 except that the coated particles 9 were used in place of the coated particles 1.

### [Analysis of coating amount of silica]

A surface of each of the prepared coated particles 1 through 9 was enlarged to 50000 times by a scanning electron microscope (product name: XL30 ESEM-FEG, manufactured by Phillips). The number of silica particles in an area of 0.5 µm square was visually measured at 10 points, an average value thereof was obtained and a coating amount of silica per unit area (1 µm²) was calculated. Calculated results of the coating amount of silica were as shown in Table 1.

### [Extraction test]

Each of the coated particles used in examples and comparative examples was mixed in a resin composition solution as mentioned above to prepare a dispersion liquid. In 2 g of the dispersion liquid, 30 g of tetrahydrofuran was added, followed by agitating for 10 min with a spatula, and coated particles were extracted from the resin composition solution. The coated particles were observed with a scanning electron microscope (product name: XL30 ESEM-FEG, manufactured by Phillips, magnification: 25000 times) to confirm whether there are insulating particles peeled off the coated particles or not. Thereby, when the coated particles are dispersed in the resin composition solution, whether there are peeled insulating particles or not may be confirmed. Those in which the peeling of the insulating particles is hardly observed is judged OK (no peeling) and those in which the insulating particles are peeled are judged NG (silica peeling). Extraction test results were as shown in Table 1.

### [Measurement of insulation resistance]

It is important in the anisotropic conductive adhesive film that the insulation resistance between chip electrodes adjacent to each other is high and the electric continuity resistance between facing chip electrode/glass electrode is low. In this connection, at first, the insulation resistance of each of the connecting material samples prepared in the respective examples and comparative examples was measured. Ten pieces of connecting material samples were prepared for each of examples and comparative examples, followed by measuring the insulation resistance between chip electrodes adjacent to each other. The minimum value of the insulation resistance and a yield (rate of good item) when one of which insulation resistance exceeds 10⁹ (Ω) was judged as good item were investigated. Measurement results of the insulation resistance were as shown in Table 1.

### [Measurement of electric continuity resistance]

In the next place, the electric continuity resistance of each of the connecting material samples prepared in the examples and comparative examples was measured. Fourteen pieces of the connecting material samples were prepared for each of the examples and comparative examples, the electric continuity resistances between facing chip electrode and glass electrode thereof were measured, an average value thereof was calculated, thereby the initial electric continuity resistance was obtained. In the next place, each of the connecting material samples was stored under the hygroscopic conditions of a temperature of 85°C and humidity of 85% for 1000 hr, thereafter the electric continuity resistances between facing chip electrode and glass electrode thereof were measured, an average value thereof was calculated, thereby the electric continuity resistance after storing under the hygroscopic condition (after hygroscopic condition) was obtained. Measurement results of the electric continuity resistance were as shown in Table 1.

**[Table 1]**

| Sample | Coating amount of silica (pieces/µm²) | Extraction test | Insulation resistance between chip electrodes (10 µm) (Note 1) | | Electric continuity resistance between chip electrode/glass electrode (Note 2) | |
|---|---|---|---|---|---|---|
| | | | Minimum value (Ω) | Yield (%) | Initial value (Ω) | After hygroscopic conditions (Ω) |
| Example 1 | 30 | OK (no peeling) | 7.9 × 10¹² | 100 | 0.99 | 14.9 |
| Example 2 | 17 | OK (no peeling) | 1.1 × 10¹² | 100 | 0.90 | 7.2 |
| Example 3 | 11 | OK (no peeling) | 5.3 × 10¹¹ | 100 | 0.83 | 5.2 |
| Example 4 | 8 | OK (no peeling) | 1.1 × 10¹¹ | 100 | 0.77 | 4.9 |
| Example 5 | 10 | OK (no peeling) | 4.9 × 10¹¹ | 100 | 0.82 | 5.0 |
| Example 6 | 29 | OK (no peeling) | 7.1 × 10¹² | 100 | 0.97 | 14.7 |
| Example 7 | 31 | OK (no peeling) | 8.3 × 10¹² | 100 | 1.01 | 14.9 |
| Comparative example 1 | 0 | - | <10⁹ | 20 | 0.54 | 3.8 |
| Comparative example 2 | 17 | NG (peeling of silica) | <10⁹ | 40 | 0.66 | 4.2 |
| Comparative example 3 (note 3) | NG (flocculation of silica) | - | - | - | - | - |

| | | | | | | |
|---|---|---|---|---|---|---|
| (Note 1): Target value ≥ 10⁹ (Ω). As to the yield, those having a value of 10⁹ (Ω) or more were counted as good item among 10 samples. (Note 2): Target value < 20 (Ω). This is an average value of 14 samples. (Note 3): Because of flocculation of silica, evaluation was impossible. | | | | | | |

According to the scanning electron microscope observation, the coated particles 1 hardly showed a variation in the adhesion state of silica before and after the extraction test. Accordingly, it was confirmed that in the coated particles 1, silica was firmly held by the functional group-containing conductive particle and did not readily peel off the functional group-containing conductive particle. It was confirmed as well that when a circuit connecting material was prepared by use of an anisotropic conductive adhesive film containing the coated particles 1 like this, the electric continuity resistance between facing electrodes was low and the insulation resistance between adjacent electrodes was made higher (Table 1).

In the coated particles 8, it was confirmed that almost all silica was peeled off after the extraction test and the adhesion state varied largely before and after the extraction test. That is, it was confirmed that in the coated particles 8 used in comparative example 2, silica readily peeled off the functional group-containing conductive particle. It was confirmed as well that a circuit connecting material prepared with the anisotropic conductive adhesive film containing the coated particles 8 like this was insufficient in the insulation resistance (Table 1).

In the invention, a coated amount of silica of the coated particle may be controlled by selecting kind and concentration of a polymer electrolyte. For example, among the examples, samples high in the coated amount of silica (examples 1, 6 and 7) have relatively high insulation resistance and electric continuity resistance. On the other hand, samples low in the coated amount of silica (examples 3, 4 and 5) are relatively low in the insulation resistance and electric continuity resistance. Furthermore, example 2 having the coated amount of silica intermediate of the two had the insulation resistance and electric continuity resistance intermediate thereof. Accordingly, the insulation property and electric continuity of a circuit connecting material may be balanced by controlling a coated amount of silica of the coated particle by selecting the kind and concentration of the polymer electrolyte.

As mentioned above, according to the invention, an anisotropic conductive adhesive composition that may respond to narrow pitch and is excellent in both of the electric continuity between facing electrodes and the insulation property between adjacent electrodes, a film provided with the anisotropic conductive adhesive composition, coated particles contained in the anisotropic conductive adhesive composition and a method for producing the coated particle may be provided.

### Industrial Applicability

As mentioned above, according to the present invention, an anisotropic conductive adhesive film excellent in the insulating property between adjacent circuit electrodes on the same substrate and in the electric continuity between facing circuit electrodes when circuit electrodes having a narrow pitch and a narrow area are connected, an anisotropic conductive adhesive composition, coated particles used in the anisotropic conductive adhesive composition and a method for producing the same may be provided.

## Claims

1. A coated particle comprising a functional group-containing conductive particle at least partially surface-coated with an insulating material, wherein
the conductive particle has a metal surface and at least a part of the metal surface has a functional group, and
the insulating material comprises polymer electrolytes and insulating particles made of an inorganic oxide having a hydroxy group on at least a part of a surface thereof.

2. The coated particle of claim 1, wherein the functional group is at least one selected from the group consisting of a hydroxyl group, a carboxyl group, an alkoxyl group and an alkoxycarbonyl group.

3. The coated particle of claim 1 or 2, wherein the functional group is formed by bringing a compound having at least one selected from the group consisting of a mercapto group, a sulfide group and a disulfide group into contact with the metal surface of the functional group-containing conductive particle.

4. The coated particle of any one of claims 1 to 3, wherein at least a part of the functional groups binds chemically to at least a part of the hydroxyl groups on the surface of the insulating particle.

5. The coated particle of any one of claims 1 to 4, wherein the polymer electrolyte is polyamine.

6. The coated particle of claim 5, wherein the polyamine is polyethyleneimine.

7. The coated particle of any one of claims 1 to 6, wherein the insulating particle is a silica particle.

8. A method for producing a coated particle comprising a functional group-containing conductive particle at least partially surface-coated with an insulating material comprising polymer electrolytes and insulating particles comprising:
a functional group forming step where a compound having at least one selected from the group consisting of a mercapto group, a sulfide group and a disulfide group is brought into contact with a metal surface of a conductive particle to form a functional group on at least a part of the metal surface to obtain the functional group-containing conductive particle; and
a coating step where the polymer electrolytes and the insulating particles made of an inorganic oxide having a hydroxyl group on at least a part of a surface thereof are brought into contact with at least a part of the surface of the functional group-containing conductive particle.

9. The method for producing a coated particle of claim 8, wherein the coating step is a step where the polymer electrolytes are brought into contact with at least a part of the surface of the functional group-containing conductive particle, followed by bringing the insulating particles into contact.

10. The method for producing a coated particle of claims 8 or 9, wherein the functional group is at least one selected from the group consisting of a hydroxyl group, a carboxyl group, an alkoxyl group and an alkoxycarbonyl group.

11. The method for producing a coated particle of any one of claims 8 to 10, wherein at least a part of the functional groups binds chemically to at least a part of the hydroxyl groups on the surface of the insulating particle.

12. The method for producing a coated particle of any one of claims 8 to 11, wherein the polymer electrolyte is polyamine.

13. The method for producing a coated particle of claim 12, wherein the polyamine is polyethyleneimine.

14. The method for producing a coated particle of any one of claims 8 to 13, wherein the insulating particle is a silica particle.

15. An anisotropic conductive adhesive composition, comprising the coated particle of any one of claims 1 to 7 and an insulating resin composition.

16. An anisotropic conductive adhesive film, wherein the anisotropic conductive adhesive composition of claim 15 is formed into film.
